**Europäisches Patentamt**

**European Patent Office**

**Office européen des brevets**

(11) Publication number : **0 490 531 A2**

# (12) EUROPEAN PATENT APPLICATION

(21) Application number : **91311018.5**

(22) Date of filing : **28.11.91**

(51) Int. Cl.⁵ : **H01L 21/203**

(30) Priority : **07.12.90 US 623466**

(43) Date of publication of application :
**17.06.92 Bulletin 92/25**

(84) Designated Contracting States :
**DE FR GB**

(71) Applicant : **AMERICAN TELEPHONE AND TELEGRAPH COMPANY**
**550 Madison Avenue**
**New York, NY 10022 (US)**

(72) Inventor : **Brasen, Daniel**
**5 New England Drive**
**Lake Hiawatha, New Jersey 07034 (US)**
Inventor : **Feldman, Leonard Cecil**
**200 Lorraine Drive**
**Berkeley Heights, New Jersey 07922 (US)**
Inventor : **Green, Martin Laurence**
**28 Seven Oaks Drive**
**Summit, New Jersey 07901 (US)**
Inventor : **Weir, Bonnie Elaine**
**35 Alexandria Drive**
**Hackettstown, New Jersey 07840 (US)**

(74) Representative : **Johnston, Kenneth Graham et al**
**AT&T (UK) LTD. AT&T Intellectual Property Division 5 Mornington Road**
**Woodford Green Essex, IG8 OTU (GB)**

(54) **Devices based on Si/Ge.**

(57)    High speed transistor devices for use in high speed circuitry such as laser driver circuitry are formed by utilizing a high temperature deposition process. For example, chemical vapor deposition performed at temperatures on the order of 900°C for deposition of Si/Ge materials leads to bipolar devices having excellent properties. In particular, such devices are mechanically stable and are relatively defect free.

EP 0 490 531 A2

## Background of the Invention

### 1. Field of the Invention

This invention relates to semiconductor devices and, in particular, to semiconductor devices based on Si/Ge alloys.

### 2. Art Background

Si/Ge alloys have provoked material investigations for quite some time. A variety of methods have been developed for depositing films of these alloys. For example, molecular beam epitaxy (MBE) and ultra high vacuum chemical vapor deposition (UHVCVD) have been employed to deposit such films. Typically the deposition temperature for these procedures is approximately 500°C-600°C. (See J.C. Bean, L.C. Feldman, A.T. Fiory, S. Nakahara and I.K. Robinson, J. Vac. Sci. and Tech A2, 436 (1984), and B.S. Meyerson, K.J. Uram and F. K. LeGoues, Appl. Phys. Lett., 53, 2555 (1988).) In another deposition process, chemical vapor deposition (CVD) is employed to deposit these films at 900°C or above. (See H.M. Manasevit, I.S. Gergis and A.B. Jones, Journal of Electronic Materials, 12, 637 (1983)).

Si/Ge films have recently been proposed for use in high speed bipolar transistors (see G.L. Patton, D.L. Harame, J.M-C. Stork, B.S. Meyerson, G.J. Scilla and E. Ganin, IEEE Elec. Dev. Lett., 10, 534 (1989).) Such transistors offer the possibility of both high gain and high speed exceeding the performance of conventional silicon bipolar transistors. For silicon bipolar transistors the bandgap differences between the base and emitter materials are relatively small because they depend only on a difference in dopant concentration. Since gain is exponentially proportional to this bandgap difference, high gain requires large doping differences which, in turn, result in increased base resistance. Thus, formation of a transistor with relatively high gain produces a concomitantly high resistance and an associated lowering of speed. Since transistors having Si/Ge base layers give a relatively high bandgap difference relative to a silicon emitter region, increased dopant differences are not required to enhance gain. Thus, in such transistors both relatively high gain and relatively high speed are obtainable.

Efforts have been made to increase the germanium content in the base to augment the gain of the transistor. However, this increase in germanium content also produces a concomitant increase in strain of the Si/Ge film. Indeed, when a Si/Ge film exceeds its critical thickness, the strain is relaxed through formation of substantial and unacceptable defect densities. (The critical film thickness depends on germanium content and is reliably calculated as discussed in J.W. Matthews, Epitaxial Growth; ed. J.W.

Matthews, Academic Press, New York, 1975, Chapter 8.) Generally, to ensure that film thickness considerations do not limit germanium content, metastable films, i.e. unrelaxed films with thickness above the critical level, have been grown. Such films are grown at deposition temperatures below about 650°C. By using a low growth temperature, the critical thickness can be exceeded without extensive relaxation since sufficient energy is not available to overcome the activation barrier between the strained and relaxed state. Thus low temperature procedures such as MBE and UHVCVD have been used for fabrication of high speed transistors having Si/Ge bases. Additionally, the low temperature deposition has the advantage of limiting the diffusion of dopants from a desired transistor area to a region where such dopants are not acceptable. For these reasons, low temperature growth has been the method employed for producing such transistors.

## Summary of the Invention

It has been found that the use of low temperatures to grow metastable or stable films, although advantageous in some respects, provides a relatively low growth rate and most significantly in the former case produces a film that during subsequent device fabrication has a strong tendency to relax, while in both cases yields a film that tends to have significant oxygen incorporation when techniques of commercial importance such as CVD are used. The use of Si/Ge films grown at temperatures of at least 700°C to thicknesses at or below the critical thickness do not have the tendency to relax (are mechanically stable), have fast growth rates, have low oxygen content, and yet have totally acceptable properties. In particular, limitations on thickness are not significant in the device fabrication and no substantial problem with dopant migration or oxygen incorporation is observed during growth. In a preferred embodiment, chemical vapor deposition employing $SiH_2Cl_2$ and $GeH_4$ precursors to form the Si/Ge film is used.

## Brief Description of the Drawings

The Figure is illustrative of an apparatus suitable for growing Si/Ge layers.

## Detailed Description

As discussed, the invention involves the high temperature growth of devices based on Si/Ge alloys. (For purpose of this disclosure, a device is a body having a multiplicity of compositionally different regions (besides electrical contact and inactive substrate regions) whose structure is designed to control in a desired manner the transport of charge so as to affect applied energy and/or information.) Various techniques are available for high temperature growth. For example, MBE or CVD are useful. However, the chemical vapor deposition approach involves equipment and processes which are typically more production-worthy and therefore, for pedagogic reasons, the invention will be described in this context. However, using analogous steps (provided a high temperature range, i.e., 700 to 1000°C, is employed), methods such as MBE are also employable.

The growth of a Si/Ge layer on a substrate is performed below the critical thickness determined from the Matthews-Blakeslee equilibrium curve (see Matthews, supra). If the deposition is confined to satisfy this law, strain will be present in the layer but it will be mechanically stable. Satisfaction of the Matthews/Blakeslee relation depends on the deposition substrate, the composition of the Si/Ge film, and the film thickness. However, suitable parameters defining the substrate and the Si/Ge composition are available in Matthews, supra, for use in the Matthews/Blakeslee determination. For many advantageous devices, such as p-i-n diodes and bipolar transistors, a single crystal silicon substrate is employed. The device region including the Si/Ge composition need not include only this material. For example, superlattice devices including alternmating regions of Si/Ge material and silicon with layer thicknesses in the range 20 Å to 400 Å are useful as the base of a bipolar transistor. Additionally, it is possible to use a region with a graded composition of Si/Ge.

In a CVD process precursor, gaseous materials are introduced to a heated substrate and undergo reaction generally at the substrate. For the formation of Si/Ge materials, gaseous silicon compounds such as dichlorosilane are advantageously employed for the silicon precursor. Other silicon gaseous materials are available and useful, but are not as advantageous as dichlorosilane. For example, silicon tetrachloride or trichlorosilane decomposes at reasonable rates at a temperature above 950°C and thus for most devices causes excessive dopant diffusion in doped regions present in the deposition substrate. Additionally, silane, although decomposing in a suitable temperature regime, induces very fast growth and thus induces control difficulties.

Similarly, a variety of materials is available as a germanium precursor. However, germane is the most conveniently employed material. Germanium tetrachloride is often not available in suitable purity for many devices and is a liquid, thus requiring additional handling associated with introduction as a gas.

Dopants are also introduced by utilizing a dopant precursor. For n-type doping, precursors such as arsine or phosphine are used to introduce respectively arsenic and phosphorus doping. Similarly, for p-type doping, diborane is advantageously employed as a precursor.

Flow rates employed depend on the Si/Ge composition desired. Typically, it is convenient to introduce the silicon, germanium, and dopant precursor in a carrier gas. Carrier gases that do not interfere with the desired reaction such as hydrogen, argon, or helium are advantageously used. Dilution levels as low as 1 mole % in the carrier gas for typical flow rates still yield advantageous growth rates. Additionally, at these lower concentrations (1 to 5 mole %), the gases are typically safer to handle. Generally the Si/Ge material layer includes from 1 to 60 mole % of germanium. For compositions less than 1 mole %, the bandgap difference is generally insufficient while for compositions of greater than 60 mole % germanium the critical thickness is so thin that formation of the layer is extremely difficult.

The flow rates employed depend on the composition desired and the degree of dilution in the carrier gas. A control sample is easily employed to determine an appropriate flow rate for a desired composition and dilution. For example, to produce Si/Ge compositions in the desired range, typical flow rates for 1% dichlorosilane in hydrogen are 0.2 SLPM to 10 SLPM, while flow rates for 1 % germane in hydrogen are advantageously in the range 0.01 SLPM to 0.5 SLPM. Lower total flow rates typically produce inconveniently slow growth rate while higher flow rates lead to growth rates sufficiently fast to produce control difficulties. Dopant materials are generally diluted to concentrations in the range 1 ppm to 10,000 ppm. For most devices dopant concentrations in the range $10^{16}$ to $10^{21}$ atoms $cm^3$ are typically employed. Typically, dopant concentrations of 10 ppm to 10,000 ppm of the dopant in the carrier gas at flow rates in the range 10 sccm to 100 sccm yield dopant concentrations in the range $10^{16}$ to $10^{21}$ atoms per $cm^3$. Generally the total pressure is maintained between 1 mTorr and 1 atmosphere. At pressures higher than 1 atmosphere control becomes somewhat difficult while at lower pressures growth rates are inconveniently low.

Typically the substrate is heated in a cold-wall reactor preferably by utilizing infrared lamps. Conveniently, the substrate temperature is determined by using a control sample. For example, a substrate is thermally connected to a thermocouple and various voltages are applied to the heating lamps. The temperature response corresponding to a particular voltage calibration is noted and in subsequent use this voltage is used to produce the corresponding temperature. Growth is essentially the same whether the precursor gases are present when heating is initiated or whether they are introduced after heating has begun. Generally, temperatures in the range from 700°C to 1000°C are employed. Typically, at temperatures below 700°C excessive oxygen is incorporated into the layer being grown, while at temperatures above 1000°C excessive germanium and dopant interdiffusion is experienced.

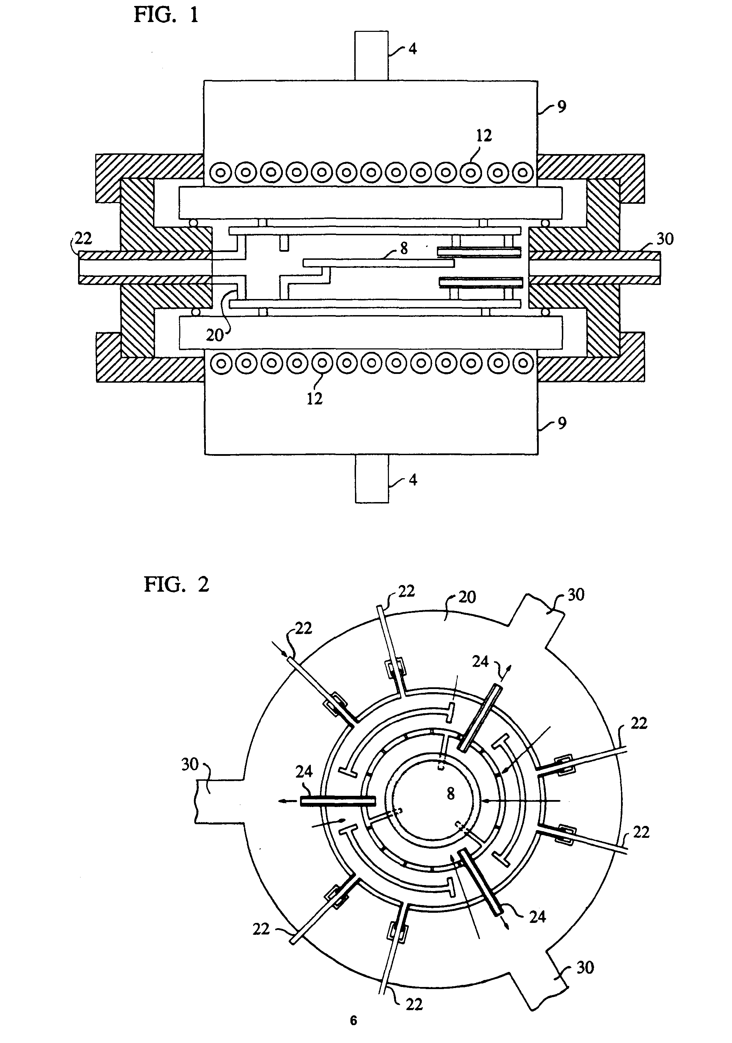

In one advantageous reactor configuration quartz plates are employed for the reactor walls. The gas flow is introduced at 20 symmetrically around the wafer as shown in FIG. 1. Similarly, exhaust is accomplished radially at 30. Typical growth rates vary with composition, temperature, and flow rate. However, generally for temperatures of approximately 900°C and Si/Ge compositions with 20% germanium, growth rates of 17 Å per second are obtained. This compares favorably with typical growth rates of 0.5 Å per second achieved with UHVCVD. Generally, oxygen contents in the range 2x $10^{17}$ oxygen atoms per $cm^3$ are obtainable, three orders of magnitude lower than reported for CVD Si/Ge films deposited at 625°C. (See C.A. King, et al., IEEE Transactions on Electronic Devices, 36, 2093 (1989).) Additionally, at the conditions described, growth of the Si/Ge material is selective on silicon to the essentially complete exclusion of growth on silicon dioxide, for layers up to several micrometers in thickness.

The following examples are illustrative conditions used in the invention.

EXAMPLE 1

The deposition substrate was a 10 mm float zone silicon wafer having its major surface in the (100) crystallographic plane and having a resistivity of 100 ohm cm or greater. This substrate was cleaned by sequential immersion in a sulfuric acid/hydrogen peroxide solution (typically 50% sulfuric acid by volume) and in a 1% by volume hydrofluoric acid solution. The substrate, 8, was then placed on the sample holder of a chemical vapor deposition apparatus so that the major surface of the substrate was substantially horizontal.

The chamber was evacuated through conduit 30 (FIG. 2) using a combination of roughing pump and cryopump to a pressure of approximately 10 $^{-7}$ Torr. To remove adsorbed impurities in the deposition chamber a bank of tungsten halogen lamps, 12, cooled by air introduced at 4 were energized and the voltage on these lamps controlled to produce a temperature of the substrate of approximately 300°C. (The temperature produced was determined earlier by using a calibration substrate having a thermally connected thermocouple and thus, through this calibration, a measured temperature was associated with an applied voltage. The lamp housing, 9, was water cooled.) The baking was continued for approximately 10 minutes. A flow of 3 liters per minute of pure hydrogen was then established through inlet 22 resulting in a chamber pressure of about 10 Torr and the voltage of the lamps increased to produce a substrate temperature of 1000°C for 15 seconds. The lamps were de-energized, and the wafer was allowed to cool to approximately 200°C. (The cooling took approximately one minute and was predetermined utilizing a calibration substrate with a thermocouple.) When the deposition substrate reached 200°C the hydrogen flow was terminated and a gas flow of 1000 cc/min of a mixture of dichlorosilane (1% by volume) in hydrogen and 30 cc/min of 10 parts per million (by volume) of arsine in hydrogen was established. (Gases were introduced as shown at 20 with gases flowing in at 22, reacting at the substrate, 8, and flowing out at 24.) By adjusting the lamp voltage, the temperature of the substrate was raised rapidly to 900°C. Growth of n-type silicon was thus initiated and was continued for approximately 3.5 minutes to produce a deposited thickness of approximately 300 nm.

The wafer again was cooled to 200°C in flowing hydrogen and after cooling the hydrogen gas flow was replaced by a flow through conduit 22 including 890 cc/min of 1% by volume dichlorosilane in hydrogen, 110 cc/min of 1% by volume germane in hydrogen and 100 cc/min of 1000 ppm by volume of diborane in hydrogen. The resulting growth of Si/Ge material was continued for 22 seconds to produce a film thickness of 300 Å, a composition of 15 atomic percent Ge in Si, and a p-dopant concentration of $10^{19}$ boron atoms per cubic cm. The substrate was again cooled in flowing hydrogen to a temperature of 200°C. The hydrogen flow was again replaced by a flow of 1 of cc/min of 1 % dichlorosilane in hydrogen, and 4 cc/min of 1000 ppm by volume of diborane in hydrogen. The deposition was continued for approximately 70 seconds to yield a 1000 Å thick p-type silicon layer with a $10^{16}$ boron atoms per $cm^3$ dopant concentration. From this multilayer n-p+-p structure, an n-p+-n heterojunction bipolar transistor was fabricated using implantation techniques and conventional processing as described in G.S. Higashi, et al., Applied Physics Letters, 56, 2560 (1990). The resulting structure exhibited a base with no relaxation defects and an oxygen concentration of approximately 2x $10^{17}$ oxygen atoms per $cm^3$. Even after device processing essentially no relaxation defects were observed by electron microscopy.

EXAMPLE 2

The procedure of Example 1 was followed except the growth temperature employed for each of the three layer depositions was 850°C rather than 900°C. Additionally, for growth of the Si/Ge layer the gas flow of dichlorosilane was 900 cc/min and the gas flow of germane was 100 cc/min. The resulting Si/Ge layer was 12 atomic percent germanium and had essentially the same characteristics as that described in Example 1.

EXAMPLE 3

The procedure of Example 1 was followed except a transistor was grown on a substrate having both silicon and silicon dioxide regions. The substrate as described in Example 1 was selectively oxidized to produce windows larger than or equal to 1 μm in a silicon dioxide region overlying the silicon substrate. This silicon dioxide region was formed by thermal oxidation. The first transistor layer was formed by the procedure of Example 1 except the dopant utilized was an 80 cc/min flow of 10 ppm arsine. The second layer was a region that had a graded concentration of germanium. The layer was 250 Å thick and varied from 7% germanium at the emitter/base interface to 15 atomic percent germanium at the base/collector interface. This grading was accomplished utilizing a total flow of 1000 cc/min of precursor gas, initially employing 110 cc/min of 1 % germanium with the remainder the dichlorosilane, and linearly decreasing the germane flow until it reached 60 cc/min. Doping of this layer was accomplished as described in Example 1. The third layer was a 1000 Å thick layer of silicon produced utilizing a 55 second deposition from 1000 cc/min flow of 1% dichlorosilane together with a 2 cc/min flow of 1000 ppm diborane. This third layer was later implanted and the transistor completed as described in Higashi, supra.

EXAMPLE 4

A superlattice was formed on a silicon substrate. The silicon substrate was prepared as described in Example 1. Twenty periods were grown on the substrate. Each period included 35 Å of a Si/Ge (11 atomic %) composition and 75 Å of silicon. The Si/Ge composition was grown as described in Example 1 except the growth was for 10 seconds utilizing a 65 cc/min 1 % germane flow and a 935 cc/min dichlorosilane flow. Each silicon region was grown for 10 seconds utilizing a 1000 cc/min dichlorosilane flow.

**Claims**

1. A process for making a device including a semiconductor region, said process comprising the steps of depositing a material comprising silicon and germanium on a device area to form at least a portion of said semiconductor region characterized in that said deposition is performed by introducing a precursor gas for said silicon and germanium material to said area wherein said area is heated to a temperature of at least 700°C.

2. The process of claim 1 wherein said device comprises a transistor.

3. The process of claim 1 wherein said region includes a graded composition of silicon and germanium.

4. The process of claim 1 wherein said region includes alternating layers of said material and a second composition.

5. The process of claim 1 wherein said temperature is at least 900°C.

6. The process of claim 1 wherein said precursor gas comprises a mixture of dichlorosilane and germane.

7. The process of claim 6 wherein said temperature is at least 900°C.

8. The process of claim 1 wherein heating to produce said temperature is accomplished using lamps.

FIG. 1

FIG. 2